# EUROPEAN PATENT SPECIFICATION

(11) **EP 3 848 963 B1**
(45) Date of publication and mention of the grant of the patent: **17.08.2022**
(21) Application number: 20151435.3
(22) Date of filing: 13.01.2020
(51) Int. Cl.: H01L 23/538, H01L 23/62, H01L 25/07, H01L 23/373

(54) **POWER SEMICONDUCTOR DEVICE**
LEISTUNGSHALBLEITERBAUELEMENT
DISPOSITIF DE SEMI-CONDUCTEUR D'ALIMENTATION

(43) Date of publication of application: 14.07.2021
(73) Proprietor: Samsung SDI Co., Ltd., Gyeonggi-do 17084 (KR)
(72) Inventor: Maxl, Florian, 8020 Graz (AT); Pretschuh, Markus, 8055 Graz (AT); Hofer, Maximilian, 8230 Hartberg (AT); Kurcik, Peter, 8505 St. Nikolai im Sausal (AT)
(74) Representative: Gulde & Partner

(56) References cited:
- WO-A1-2013/038749
- DE-A1-102014 006 841
- US-A- 3 832 769

## Description

### Field of the Invention

The present invention relates to a power semiconductor device for a vehicle. Further, in another aspect, the invention relates to a battery system comprising such power semiconductor device and a vehicle with such battery system.

### Technological Background

In recent years, vehicles have been developed using electric power as a source of motion. An electric vehicle is an automobile that is powered by an electric motor using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while highcapacity rechargeable batteries are used as the power supply for hybrid vehicles and the like.

Rechargeable batteries may be used as a battery module formed of a plurality of unit battery cells coupled in series and/or in parallel so as to provide a high energy density, in particular for motor driving of a hybrid vehicle. A battery module may be formed by interconnecting the electrode terminals of the plurality of unit battery cells depending on a required amount of power and in order to realize a high-power rechargeable battery. The cells can be connected in series, parallel or in a mixture of both to deliver the desired voltage, capacity, or power density. Components of battery packs include the individual battery modules and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers.

Battery systems usually comprise a battery control unit, often referred to as battery management unit (BMU) and/or battery management system (BMS), for processing the aforementioned information. The battery control unit may comprise controllers of the various electrical consumers and contain suitable internal communication busses, e.g. a SPI or CAN interface. The battery control unit may further communicate with each of the battery submodules, particularly with a cell supervision circuit (CSC) of each battery submodule. The CSC may be further connected to a cell connection and sensing unit (CCU) of a battery submodule that interconnects the battery cells of the battery submodule. Thus, the battery control unit may be provided for managing the battery pack, such as by protecting the battery from operating outside its safe operating area, monitoring its state, calculating secondary data, reporting that data, controlling its environment, authenticating it and/or balancing it. Typically, the battery control unit may control a relay to a load and may switch the load in various fault situations.

Battery systems for vehicles are high-voltage applications such that heat is generated in various current-conducting semiconductor devices due to resistive loss. Therefore, semiconductor devices as for example Power-MOSFETs require cooling techniques that drag the heat away from the device to preventing performance drops or defects due to overheating. The WO 2013/038749 A1 discloses a semiconductor device with a switching element between a first and a second terminal, wherein a wiring sheet is attached to the first terminal. The US 3 832 769 A discloses a method for mounting a semiconductor chip to printed circuitry. The DE 10 2014 006 841 A1 discloses a device with several metal base sheets and transistors with are placed to mechanically and electrically connect the separated base sheets in a lateral manner.

Conventionally, Power-MOSFETs or other power semiconductor devices are mounted on a rigid printed circuit board (PCB) requiring a large number of thermal conductive vertical interconnect access (VIAs) to direct a heat flow away from the device and toward a sink. Present technologies to cool the power semiconductor devices, in particular MOSFETs, are expensive and/or require a rather complex design for the PCB. That is further accompanied with intricate connections to electrically contact the device.

It is thus an object of the present invention to overcome or at least mitigate some of the drawbacks of the prior art.

### Summary of Invention

Embodiments of the present invention provide a power semiconductor and a battery system with such power semiconductor. Another aspect is a vehicle with such battery system.

According to one aspect of the invention a power semiconductor device for a vehicle is provided according to claim 1.

A power semiconductor may be a semiconductor suitable for high-voltage applications as required for the use in vehicles. For example, applied voltages may have an order of magnitude of about 12 volt, 24 volt, 48 volt or more and with electric currents with the magnitude of about 1 ampere, but the invention is not restricted thereto. A power semiconductor according to the invention may be for example a diode or a transistor. Preferably, the power semiconductor may be a field-effect transistor, in particular a MOSFET. The base metal sheet can be electrically contacted to measure or to supply a voltage to the first power pad.

In other words, the conductive pad of the flexible PCB may be a conductive portion of a conductive layer of the flexible PCB on its main side electrically contacting the first power pad and on its opposite main side contacting the metal sheet. Each main side of the conductive pad or portion may be for example laid open to form the electrical contact. Positioned between may be referred to in other words to sandwiched between.

The flexible printed circuit board according to the invention has a higher thermal conductivity than the rigid counterparts. Thermally conductive VIAs are not required due to the high thermal conductivity of the flexible PCB. The material of the flexible PCB may preferably be a polyimide or a polyetheretherketon, but the invention is not restricted thereto. Heat produced in the power semiconductor device can be readily carried away through the flexible PCB, without the need of VIAs, and through the base metal sheet in vertical direction to improve the cooling performance and to reduce local overheating. A cost reduction is achieved compared to conventional rigid PCBs. A further advantage is that the semiconductor device can be wireconnected through the flexible PCB.

The power semiconductor may comprise a second power pad on a side facing away from the flexible PCB, the power semiconductor device further comprising a top metal sheet electrically connected to the second power pad of the power semiconductor. This allows to readily contacting the second power pad.

A height of the flexible PCB may be less than 100 µm, preferably less than 70 µm, more preferably less than 40 µm. When less than 100 µm, the thermal resistance in vertical direction is particularly reduced. Less than 70 µm or even more when less than 40 µm, the thermal resistance in vertical direction is even more reduced and the amount of heat is efficiently carried away without the need of a large number of VIAs.

The flexible PCB may be a one-layer flexible PCB comprising one conductive layer, wherein the conductive layer comprises the conductive pad. A one-layer PCB compared to two-layer PCB or multi-layer PCB has furthermore reduced thermal resistance in vertical direction.

The power semiconductor may be soldered on one side of the flexible PCB and the base metal sheet may be soldered on the other side of the flexible PCB and/or the top metal sheet may be soldered on the power semiconductor. The soldering provides a structurally stable electrically conductive connection.

The semiconductor may be a field-effect transistor, further comprising a gate power pad, the gate power pad positioned on the side of the semiconductor facing the flexible PCB, wherein the first power pad is a power drain pad and the second power pad is a power source pad. Field-effect transistors may be used in various vehicle applications. For example, the field-effect transistor may be used as the substitute of a relay to switch off a load in case of a detected fault in the battery system. When the gate power pad is positioned in the described manner, it can be readily connected via conductive tracks within the flexible PCB. A cumbersome implementation of a connection can be avoided.

The flexible PCB may comprise a protruding section, which protrudes from the power semiconductor and/or from the base metal sheet and/or the top metal sheet in a plan view. In other words, the protruding section does not overlap with the power semiconductor and/or the base metal sheet and/or the top metal sheet in a plan view. Such protruding section allows externally contacting the gate bad. Conductive tracks may be in other words conductive lines.

The flexible PCB may comprise a conductive track electrically connecting the gate power pad to a gate connector for external contact, the gate connector positioned in the protruding section of the flexible PCB. Such breaking out of the gate connector is advantageous since it simplifies the connection to the gate power pad. Costs for elaborate connections are avoided and compactness may be improved.

The base metal sheet and/or the top metal sheet may be of copper or comprises copper, and the base and/or the top metal sheet may comprise a connector for external contact. Copper has high electric conductivity. The connectors on the sheets allow direct contacting the pads of the semiconductor and may also function as common source for more than one semiconductor.

The power semiconductor device comprises a plurality of semiconductors. For example, the number of power semiconductor devices may be 2, 4, 6, 7, 8, 10 or more, but the invention is not restricted thereto.

The power semiconductor device comprises a first subset and a second subset of semiconductors, wherein each conductive pad of the first subset of semiconductors is electrically isolated from each electrically conductive pad of the second subset in the flexible PCB. This allows to have different potentials on the power pads of the different subsets.

The base metal sheet comprises a first base metal sheet and second base metal sheet, each base metal sheet being electrically isolated from each other, wherein each electrically conductive pad of the first subset of semiconductors is electrically connected to a first power pad of the first subset of semiconductors and to the first base metal sheet, and wherein each electrically conductive pad of the second subset of semiconductors is electrically connected to a first power pad of the second subset of semiconductors and to the second base metal sheet. The first power pads of the same subset can be commonly contacted via the first base metal sheet and the first power pads of the second subset can then be commonly contacted via the second base metal sheets, respectively individual.

The power semiconductor device may comprise a heat sink attached on the side of the base metal sheet facing away of the flexible PCB. Heat generated by the device can then be readily transported via the flexible PCB and through its highly conductive material and the base metal sheet without the requirement of VIAs.

According to another aspect of the invention a battery system is disclosed comprising a battery control unit electrically connected to the power semiconductor device of one of the above embodiments and, the battery control unit configured to control the power semiconductor device. The battery control unit may be electrically connected to the connectors of the metal sheets and the gate connector.

According to yet another aspect a vehicle comprising a battery system according to one of the above described embodiments is disclosed.

### Brief Description of the Drawings

Features will become apparent to those of ordinary skill in the art by describing in detail exemplary embodiments with reference to the attached drawings in which:
- Fig. 1: illustrates a schematic side view of a semiconductor device according to an embodiment of the invention; and
- Fig. 2: illustrates a top view of a semiconductor device according an embodiment and a battery system according to an embodiment of the invention.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various features, these features should not be limited by these terms. These terms are only used to distinguish one element from another element. For example, a first element may be named a second element and, similarly, a second element may be named a first element, without departing from the scope of the present invention.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or height of each element may be arbitrarily shown for illustrative purposes, and thus the embodiments of the present invention should not be construed as being limited thereto.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

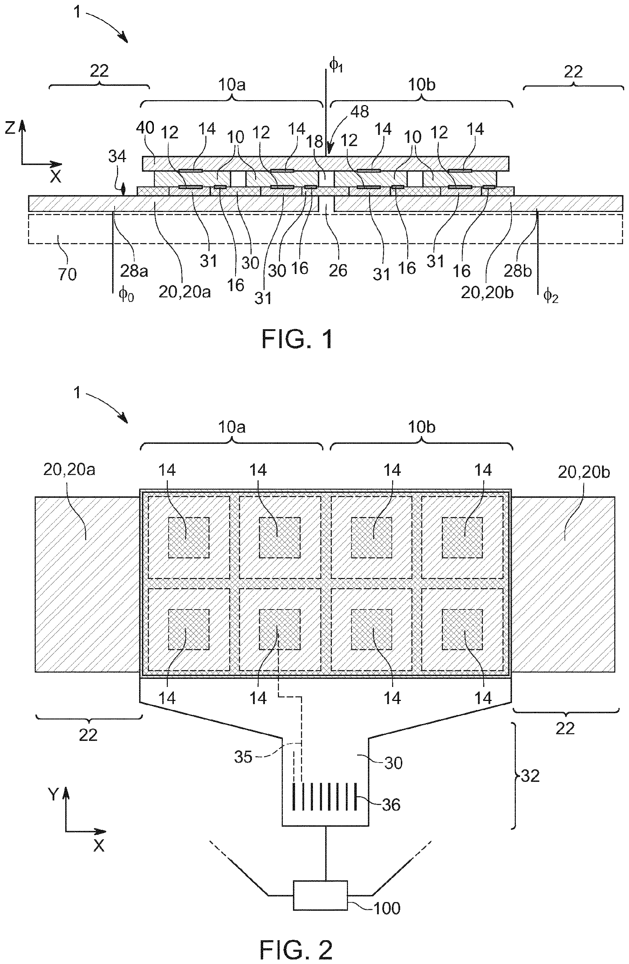

Fig. 1 shows a power semiconductor device 1 for a vehicle in an exemplary embodiment of the invention in side view perspective. Z-axis refers to a vertical direction and x-axis to a planar direction, see the coordinate system. Fig. 2, see below, will refer to plan view in the x-y-plane. The power semiconductor device 1 comprises a power semiconductor 10. In the present side view, four different semiconductors 10 are disclosed, but the invention is not restricted thereto and may have for example 1, 2, 6, 7, 8, 10 or more semiconductors. The power semiconductor device 1 further comprises a base metal sheet 20. The base metal sheet 20 may be two-parted with a first and a second base metal sheet 20a, 20b as described later. The invention may also include the case where the base metal sheet 20 is one-parted (not shown in Figures).

The power semiconductor device 1 further comprises a flexible printed circuit board PCB 30.

The flexible PCB is positioned between the base metal sheet 20 and the at least one power semiconductor 10. Each power semiconductor 10 comprises a first power pad 12 on a side facing the flexible PCB 30.

The flexible PCB 30 further comprises an electrically conductive pad 31. In other words, the conductive pad 31 may be a conductive portion in a conductive layer of the flexible PCB, for example laid open on its both main sides to provide electrical contact. One side of that conductive pad 31 is electrically connected to the first power pad 12 of the semiconductor and the opposite side of the pad 31 is electrically connected to the base metal sheet 20, 20a, 20. The conductive pad 31 thus electrically connects the first power pad 12 through the flexible PCB 30 to the metal sheet being on equal electrical potential.

The technical effect achieved is that thermally conductive VIAs as used in rigid PCBs are not required due to the high thermal conductivity of the flexible PCB 30. Heat produced in the power semiconductor device can be readily carried away through the flexible PCB 30 itself, without thermal VIAs, and through the base metal sheet in vertical direction. Cooling performance is improved and local overheating avoided in simple way. The material of the flexible PCB 30 may be preferably a polyimide or a polyetheretherketon, but the invention is not restricted thereto.

In this example embodiment, a heat sink 70 is positioned on the side of the base metal sheet 20 facing away from the flexible PCB 30 and may be attached thereto. Heat produced due to dissipation in the power semiconductor 10 may then be conducted vertically through the flexible PCB 30 and the first base metal sheet 20 to the heat sink 70.

In this embodiment, the height 34 of the flexible PCB 30 is less than 100 µm. Even more preferred, the height 34 may be less than 70 µm or more preferably less than 40 µm. In particular, when the height 34 is below the threshold value of 100 µm, the thermal resistance of the flexible PCB 30 is substantially lower than for rigid PCBs. Heat is then readily transported through the flexible PCB 30. The effect is even stronger, when the height 34 is less than 70 µm or even less than 40 µm.

To improve further the reduction of thermal resistance, the flexible PCB 30 is in this exemplary embodiment a one-layer flexible PCB. Preferably, the conductive layer comprises the conductive pad 31, which is schematically shown in Fig. 1. Compared two-layer flexible PCBs or multi-layered flexible PCBs, the thermal conductivity is improved such that heat is effectively transported away from the power semiconductor 10 to a heat sink 70.

The power semiconductor 10, in this exemplary embodiment, comprises a second power pad 14 on a side facing away from the flexible PCB 30. The power semiconductor device 1 may further comprise a top metal sheet 40 electrically connected to the second power pad 14 of the semiconductor 10.

A power diode may be formed in this manner. Furthermore, the metal sheets 20, 20a, 20b, 40 may comprise, as shown in Fig. 1 a connector 28a, 28b, 48 for external contact. Here, as explained below, two connectors 28 a, 28b are disclosed regarding the two-parted base metals sheet 28a, 28b. In other embodiments, the base metals sheet 20 may be one-parted and only one (common) connector would be required. The locations of the connectors 28a, 28b, 48 on the metal sheets are only exemplary and the person skilled in the art would find the convenient positions therefore.

The base metal sheet 20 and/or the top metal sheet 40 may be of copper or comprises copper providing a high electric conductivity, but the invention is not restricted thereto. In particular, in this example embodiment, the top metal sheet 40 is electrically connected to each of the second power pads 14 of the power semiconductors 10. That is, the electrical potential ϕ₁ at the top connector 40 coincides with each potential of second power pads 14 of the semiconductors 10. The second power pad 14, as shown in the Figs. 1 and 2 may preferably be configured as an exposed pad 14 on the top side of the power semiconductor 10.

The power semiconductor 10 is preferably soldered on one side of the flexible PCB 30 and the base metal sheet 20 is preferably soldered on the other side of the flexible PCB 30. Soldering is the preferable way to electrically connect and fasten the metal sheets 20a, 20b, 40 or the power semiconductor 10 to the flexible PCB 30. Also, the top metal sheet 40 may be soldered on the power semiconductor 10.

In this example embodiment, the power semiconductor 10 is a field-effect transistor, preferably a MOSFET transistor. The field-effect transistor comprises further a gate power pad 16. The gate power pad 16 may preferably be positioned, as can be seen in Fig. 1, on the side of the semiconductor 10 facing the flexible PCB 30. The first power pad 12 may be a power drain pad and the second power pad 14 may be a power source pad. The field-effect transistor may function as a switch in a battery system to switch a load in case of a fault detected.

The power semiconductor device 10 may comprises a plurality of power semiconductors 10. For example, in the present embodiment, the number of power semiconductors is 4 or 8, the latter when viewed in a plan view, see Fig. 2, but the invention is not restricted thereto and the number of semiconductors may be 1, 2, 6, 12 or more. The power semiconductors 10 may be arranged in a line, a double-line as in Fig. 2 or more general in a matrix format. These power semiconductors 10 may be spatially distanced from each other. For example, between each power semiconductor 10, an air gap 18 may be provided to avoid interference.

As can be seen explicitly in the example embodiment of Fig. 2 and described later, the power semiconductor device 1 may comprise a first subset 10a of power semiconductors 10 and a second subset 10b of power semiconductors 10. Each conductive pad 31 of the first subset 10a of power semiconductors 10 is electrically isolated from each conductive pad 31 of the second subset 10b in the flexible PCB 30. This allows that conductive pads 31 and the connected first power pads 12 of different subsets 10a, 10b may have different electrical potential.

In particular, the base metal sheet 20 may comprise a first base metal sheet 20a and second base metal sheet 20b. Each base metal sheet 20a, 20b may be electrically isolated from each other. For example, as shown in Fig. 1, between the two base metal sheets 20a, 20b may be an air gap 26 to separate the base metal sheets.

The electrically conductive pad 31 of the first subset 10a of power semiconductors 10 may be electrically connected to the first power pad 12 of the first subset 10a of power semiconductors 10 and to the first base metal sheet 20a. The electrically conductive pad 31 of the second subset 10b of power semiconductors 10 may be electrically connected to the first power pad 12 of the second subset 10b of power semiconductors 10 and with the second base metal sheet 20b.

That is, in such an example embodiment, the first base metal sheet 20a and the corresponding first power pads 12 may be on a different potential as the second base metal sheet 20b. For example, a connector 28a of the first metal sheet 20a may be on an electrical potential (ϕ₀, the connector 48 of the top metal sheet 40 may be on an electrical potential ϕ₁ and the connector 28b of the second metal sheet 20b may be on an electrical potential ϕ₂. Each of the potentials can be different from each other.

When the power gate pad 16 is supplied with voltage above a threshold voltage, an electrical current may for example flow from the first base metal sheet 20a to the second base metal sheet 20b through the first subset 10a, the top metal sheet 40, the second subset 10b in case of ϕ₀ > ϕ₁ > ϕ₂ or vice versa. The current may be a charging current or a discharging current of a battery system to charge or discharge the battery cells of a battery stack.

In other embodiments, when only a single base metal sheet 20 is provided, an electric current may flow from the base metal sheet 20 to the top metal sheet 40 through the power semiconductors based on the gate voltage in case of a transistor and the respective electrical potentials.

The example embodiments of the described power semiconductors may be used in an embodiment of a battery system, where instead of a common relay a switch transistor with the above described features to switch a load in case of a detected fault situation may be used.

Fig. 2 shows a power semiconductor device 1 according to Fig. 1 in a plan view perspective. Features already described in Fig. 1 are not repeated for the sake of conciseness, for the corresponding features the reader is referred to Fig. 1 and the description thereto.

In this example embodiment, the flexible PCB 30 comprises a protruding section 32, which protrudes from the power semiconductor 10, from the base metal sheet 20 and the top metal sheet 40 in a plan view. In other embodiments, the protruding section 32 may protrude from at least one of the power semiconductor 10, from the base metal sheet 20 and the top metal sheet 40 in a plan view.

The flexible PCB 30 may further comprise, as can be seen in Fig. 2, at least one conductive track 35 electrically connecting a gate power pad 16 of the power semiconductor 10, see Fig. 1, to a gate connector 36 for external contact. As example, one of the conductive tracks 35 is shown leading to a gate pad for illustration. The gate connector 36 in this preferred embodiment is positioned in the protruding section 32 of the flexible PCB 30. Thereby, the gate connector 36 is broken out and simplifies to externally contact the gate power pad 16. Via the protruded section 32 with gate connector 36 combined with the flexible material property, positioning and integration of the power semiconductor device 1 in larger systems may be improved.

Further, in this exemplary embodiment, the base metal sheet 20 may also have a protruding section 22 which protrudes from the flexible PCB 30, the semiconductor 10 and the top metal sheet 40, the protruding direction substantially perpendicular to the protruding direction of the protruding section 32 of the flexible PCB 30. In a further embodiment, the connectors 28a, 28b may be positioned in the protruding section 22 to improve the convenience of an external contact to the first gate pad 12.

Further, an exemplary embodiment of a battery system is disclosed in Fig. 2 comprising a battery control (or management) unit 100, which is electrically connected to the power semiconductor device 1. The battery control unit 100 may control the power semiconductor device 1. For example, when the power semiconductor device 1 is a field-effect transistor, in particular a MOSFET, the battery system may utilize the field-effect transistor as a switching transistor to switch a load. The battery control system 100 may be configured to switch the field-effect transistor off in case of a detected fault.

In the present example embodiment, the battery control unit 100 is electrically connected to the gate connector 36 of the power semiconductor device 1. The gate connector 36 may be a common connector to control the gate of each of the power semiconductors 10 at once, when a plurality of power semiconductors 10 is present. Additionally, the battery control unit 100 may be electrically connected to the connector 48 of the top metal sheet 40 and/or with the connectors 28a, 28b of the base metal sheet 20 monitoring or supplying voltage.

In other embodiments, when the power semiconductor device is not a transistor, only electrical connection with the connector 48 of the top metal sheet 40 and/or with the connectors 28a, 28b of the base metal sheet 20 may be present.

Additionally, a vehicle is disclosed (not shown explicitly), which may comprise a battery system according to the above embodiments.

### Reference signs

- 1: power semiconductor device

- 10: power semiconductor
- 10a: first subset
- 10b: second subset
- 12: first power pad
- 14: second power pad
- 16: gate power pad
- 18: gap

- 20: base metal sheet
- 20a: first base metal sheet
- 20b: second base metal sheet
- 22: protruding section
- 26: gap
- 28a: connector
- 28b: connector

- 30: flexible printed circuit board (PCB)
- 31: pad
- 32: protruding section
- 34: height
- 35: conductive track
- 36: gate connector

- 40: top metal sheet
- 48: connector

- 70: heat sink

- 100: battery control system

## Claims

1. A power semiconductor device (1) for a vehicle, comprising:
- a power semiconductor (10);
- a base metal sheet (20); and
- a flexible printed circuit board, PCB (30), positioned between the base metal sheet (20) and the power semiconductor (10);
wherein the power semiconductor (10) comprises a first power pad (12) on a side facing the flexible PCB (30); and
wherein the flexible PCB (30) comprises an electrically conductive pad (31), one side of the conductive pad (31) electrically connected to the first power pad (12) of the power semiconductor (10) and the opposite side of the conductive pad (31) electrically connected to the base metal sheet (20),
**characterized in that**,
the power semiconductor device (1) comprises a first subset (10a) and a second subset (10b) of power semiconductors (10), wherein each conductive pad (31) of the first subset (10a) of semiconductors (10) is electrically isolated from each electrically conductive pad (31) of the second subset (10b) in the flexible PCB (30),
wherein the base metal sheet (20) comprises a first base metal sheet (20a) and second base metal sheet (20b), each base metal sheet (20a, 20b) being electrically isolated from each other, wherein each electrically conductive pad (31) of the first subset (10a) of power semiconductors (10) is electrically connected to a first power pad (12) of the first subset (10a) of power semiconductors (10) and to the first base metal sheet (20a), and wherein each electrically conductive pad (31) of the second subset (10b) of power semiconductors (10) is electrically connected to a first power pad (12) of the second subset (10b) of power semiconductors (10) and to the second base metal sheet (20b).

2. The power semiconductor device (1) of claim 1, wherein the power semiconductor (10) comprises a second power pad (14) on a side facing away from the flexible PCB (30), the power semiconductor device (1) further comprising a top metal sheet (40) electrically connected to the second power pad (14) of the power semiconductor (10).

3. The power semiconductor device (1) of one of the claims 1 to 2, wherein a height (34) of the flexible PCB (30) is less than 100 µm, preferably less than 70 µm, more preferably less than 40 µm.

4. The power semiconductor device (1) of one of the claims 1 to 3, wherein the flexible PCB (30) is a one-layer flexible PCB comprising one conductive layer, wherein the conductive layer comprises the conductive pad (31).

5. The power semiconductor device (1) of one of the claims 1 to 4, wherein the power semiconductor (10) is soldered on one side of the flexible PCB (30) and the base metal sheet (20) is soldered on the opposite side of the flexible PCB (30) and/or the top metal sheet (40) is soldered on the side of the power semiconductor (10) facing away from the flexible PCB (30).

6. The power semiconductor device (1) of one of the claims 1 to 5, wherein the semiconductor (10) is a field-effect transistor, further comprising a gate power pad (16), the gate power pad (16) positioned on the side of the semiconductor (10) facing the flexible PCB (30), wherein the first power pad (12) is a power drain pad and the second power pad (14) is a power source pad.

7. The power semiconductor device (1) of claim 6, the flexible PCB (30) comprising a protruding section (32), which protrudes from the power semiconductor (10) and/or from the base metal sheet (20) and/or the top metal sheet (40) in a plan view.

8. The power semiconductor device (1) of claim 7, wherein the flexible PCB (30) further comprises a conductive track (35) electrically connecting the gate power pad (16) to a gate connector (36) for external contact, the gate connector (36) positioned in the protruding section (32) of the flexible PCB (30).

9. The power semiconductor device of one of the claims 1 to 8, wherein the base metal sheet (20) and/or the top metal sheet (40) is of copper or comprises copper, and wherein the base and/or top metal sheet (20, 40) comprise a connector (28a, 28b, 48) for external contact.

10. The power semiconductor device (10) of one of the claims 1 to 9, further comprising a heat sink (70) attached on the side of the base metal sheet (20) facing away from the flexible PCB (30).

11. A battery system comprising a battery control unit (100) electrically connected to a power semiconductor device (1) of one of the claims 1 to 10, the battery control unit (100) configured to control the power semiconductor device (1).

12. A vehicle comprising a battery system according to claim 11.

## Patentansprüche

1. Leistungshalbleitervorrichtung (1) für ein Fahrzeug, die umfasst:
- einen Leistungshalbleiter (10);
- ein Unedelmetallblech (20); und
- eine flexible gedruckte Leiterplatte (Printed Circuit Board, PCB) (30), die zwischen dem Unedelmetallblech (20) und dem Leistungshalbleiter (10) positioniert ist;
wobei der Leistungshalbleiter (10) eine erste Stromkontaktfläche (12) auf einer der flexiblen PCB (30) zugewandten Seite umfasst; und
wobei die flexible PCB (30) eine elektrisch leitfähige Kontaktfläche (31) umfasst, wobei eine Seite der leitfähigen Kontaktfläche (31) elektrisch mit der ersten Stromkontaktfläche (12) des Leistungshalbleiters (10) verbunden ist und die gegenüberliegende Seite der leitfähigen Kontaktfläche (31) elektrisch mit dem Unedelmetallblech (20) verbunden ist,
**dadurch gekennzeichnet, dass**
die Leistungshalbleitervorrichtung (1) eine erste Teilmenge (10a) und eine zweite Teilmenge (10b) von Leistungshalbleitern (10) umfasst, wobei jede leitfähige Kontaktfläche (31) der ersten Teilmenge (10a) von Halbleitern (10) elektrisch von jeder elektrisch leitfähigen Kontaktfläche (31) der zweiten Teilmenge (10b) in der flexiblen PCB (30) isoliert ist,
wobei das Unedelmetallblech (20) ein erstes Unedelmetallblech (20a) und ein zweites Unedelmetallblech (20b) umfasst, wobei jedes Unedelmetallblech (20a, 20b) elektrisch vom anderen isoliert ist, wobei jede elektrisch leitfähige Kontaktfläche (31) der ersten Teilmenge (10a) von Leistungshalbleitern (10) elektrisch mit einer ersten Stromkontaktfläche (12) der ersten Teilmenge (10a) von Leistungshalbleitern (10) und mit dem ersten Unedelmetallblech (20a) verbunden ist, und wobei jede elektrisch leitfähige Kontaktfläche (31) der zweiten Teilmenge (10b) von Leistungshalbleitern (10) elektrisch mit einer ersten Stromkontaktfläche (12) der zweiten Teilmenge (10b) von Leistungshalbleitern (10) und mit dem zweiten Unedelmetallblech (20b) verbunden ist.

2. Leistungshalbleitervorrichtung (1) nach Anspruch 1, wobei der Leistungshalbleiter (10) eine zweite Stromkontaktfläche (14) auf einer von der flexiblen PCB (30) abgewandten Seite umfasst, wobei die Leistungshalbleitervorrichtung (1) des Weiteren ein oberes Metallblech (40) umfasst, das elektrisch mit der zweiten Stromkontaktfläche (14) des Leistungshalbleiters (10) verbunden ist.

3. Leistungshalbleitervorrichtung (1) nach einem der Ansprüche 1 und 2, wobei eine Höhe (34) der flexiblen PCB (30) weniger als 100 µm, bevorzugt weniger als 70 µm, besonders bevorzugt weniger als 40 µm beträgt.

4. Leistungshalbleitervorrichtung (1) nach einem der Ansprüche 1 bis 3, wobei die flexible PCB (30) eine einschichtige flexible PCB ist, die eine einzelne leitfähige Schicht ist, wobei die leitfähige Schicht die leitfähige Kontaktfläche (31) umfasst.

5. Leistungshalbleitervorrichtung (1) nach einem der Ansprüche 1 bis 4, wobei der Leistungshalbleiter (10) auf einer Seite der flexiblen PCB (30) angelötet ist und das Unedelmetallblech (20) auf der gegenüberliegenden Seite der flexiblen PCB (30) angelötet ist, und/oder das obere Metallblech (40) auf der von der flexiblen PCB (30) abgewandten Seite des Leistungshalbleiters (10) angelötet ist.

6. Leistungshalbleitervorrichtung (1) nach einem der Ansprüche 1 bis 5, wobei der Halbleiter (10) ein Feldeffekttransistor ist und des Weiteren eine Gate-Stromkontaktfläche (16) umfasst, wobei die Gate-Stromkontaktfläche (16) auf der der flexiblen PCB (30) zugewandten Seite des Halbleiters (10) angeordnet ist, wobei die erste Stromkontaktfläche (12) eine Stromabzugskontaktfläche ist und die zweite Stromkontaktfläche (14) eine Stromquellenkontaktfläche ist.

7. Leistungshalbleitervorrichtung (1) nach Anspruch 6, wobei die flexible PCB (30) einen vorstehenden Abschnitt (32) aufweist, der in einer Draufsicht von dem Leistungshalbleiter (10) und/oder von dem Unedelmetallblech (20) und/oder dem oberen Metallblech (40) vorsteht.

8. Leistungshalbleitervorrichtung (1) nach Anspruch 7, wobei die flexible PCB (30) des Weiteren eine Leiterbahn (35) umfasst, die die Gate-Stromkontaktfläche (16) elektrisch mit einem Gate-Verbinder (36) verbindet, um einen externen Kontakt herzustellen, wobei der Gate-Verbinder (36) in dem vorstehenden Abschnitt (32) der flexiblen PCB (30) positioniert ist.

9. Leistungshalbleitervorrichtung nach einem der Ansprüche 1 bis 8, wobei das Unedelmetallblech (20) und/oder das obere Metallblech (40) Kupfer sind oder Kupfer umfassen, und wobei das Unedel- und/oder das obere Metallblech (20, 40) einen Verbinder (28a, 28b, 48) umfassen, um einen externen Kontakt herzustellen.

10. Leistungshalbleitervorrichtung (10) nach einem der Ansprüche 1 bis 9, die des Weiteren eine Wärmesenke (70) umfasst, die auf der von der flexiblen PCB (30) abgewandten Seite des Unedelmetallblechs (20) angebracht ist.

11. Batteriesystem, das eine Batteriesteuereinheit (100) umfasst, die elektrisch mit einer Leistungshalbleitervorrichtung (1) nach einem der Ansprüche 1 bis 10 verbunden ist, wobei die Batteriesteuereinheit (100) zum Steuern der Leistungshalbleitervorrichtung (1) konfiguriert ist.

12. Fahrzeug, das ein Batteriesystem nach Anspruch 11 umfasst.

## Revendications

1. Dispositif (1) à semi-conducteurs de puissance pour un véhicule, comprenant :
- un semi-conducteur (10) de puissance ;
- une feuille métallique de base (20) ; et
- une carte de circuit imprimé flexible, PCB (30), positionnée entre la feuille métallique de base (20) et le semi-conducteur (10) de puissance ;
dans lequel le semi-conducteur (10) de puissance comprend une première pastille d'alimentation (12) sur un côté faisant face à la PCB flexible (30) ; et
dans lequel la PCB flexible (30) comprend une pastille conductrice (31) d'électricité, un côté de la pastille conductrice (31) étant relié électriquement à la première pastille d'alimentation (12) du semi-conducteur (10) de puissance, et le côté opposé de la pastille conductrice (31) étant relié électriquement à la feuille métallique de base (20),
**caractérisé en ce que**,
le dispositif (1) à semi-conducteurs de puissance comprend un premier sous-ensemble (10a) et un deuxième sous-ensemble (10b) de semi-conducteurs (10) de puissance, dans lequel chaque pastille conductrice (31) du premier sous-ensemble (10a) de semi-conducteurs (10) est électriquement isolée de chaque pastille conductrice (31) d'électricité du deuxième sous-ensemble (10b) dans la PCB flexible (30),
dans lequel la feuille métallique de base (20) comprend une première feuille métallique de base (20a) et une deuxième feuille métallique de base (20b), chacune des feuilles métalliques de base (20a, 20b) étant électriquement isolée l'une de l'autre, dans lequel chaque pastille conductrice (31) d'électricité du premier sous-ensemble (10a) de semi-conducteurs (10) de puissance est électriquement reliée à une première pastille d'alimentation (12) du premier sous-ensemble (10a) de semi-conducteurs (10) de puissance et à la première feuille métallique de base (20a), et dans lequel chaque pastille conductrice (31) d'électricité du deuxième sous-ensemble (10b) de semi-conducteurs (10) de puissance est électriquement reliée à une première pastille d'alimentation (12) du deuxième sous-ensemble (10b) de semi-conducteurs (10) de puissance et à la deuxième feuille métallique de base (20b).

2. Dispositif (1) à semi-conducteurs de puissance selon la revendication 1, dans lequel le semi-conducteur (10) de puissance comprend une deuxième pastille d'alimentation (14) sur un côté à l'opposé de la PCB flexible (30), le dispositif (1) à semi-conducteurs de puissance comprenant en outre une feuille métallique supérieure (40) reliée électriquement à la deuxième pastille d'alimentation (14) du semi-conducteur (10) de puissance.

3. Dispositif (1) à semi-conducteurs de puissance de l'une des revendications 1 et 2, dans lequel une hauteur (34) de la PCB flexible (30) est inférieure à 100 µm, de préférence inférieure à 70 µm, de manière davantage préférée inférieure à 40 µm.

4. Dispositif (1) à semi-conducteurs de puissance de l'une des revendications 1 à 3, dans lequel la PCB flexible (30) est une PCB flexible à couche unique comprenant une couche conductrice, la couche conductrice comprenant la pastille conductrice (31).

5. Dispositif (1) à semi-conducteurs de puissance de l'une des revendications 1 à 4, dans lequel le semi-conducteur (10) de puissance est soudé sur un côté de la PCB flexible (30), et la feuille métallique de base (20) est soudée sur le côté opposé de la PCB flexible (30) et/ou la feuille métallique supérieure (40) est soudée sur le côté du semi-conducteur (10) de puissance à l'opposé de la PCB flexible (30).

6. Dispositif (1) à semi-conducteurs de puissance de l'une des revendications 1 à 5, dans lequel le semi-conducteur (10) est un transistor à effet de champ, comprenant en outre une pastille d'alimentation de grille (16), la pastille d'alimentation de grille (16) étant positionnée sur le côté du semi-conducteur (10) faisant face à la PCB flexible (30), la première pastille d'alimentation (12) étant une pastille de drain d'alimentation et la deuxième pastille d'alimentation (14) étant une pastille de source d'alimentation.

7. Dispositif (1) à semi-conducteurs de puissance de la revendication 6, dans lequel la PCB flexible (30) comprend une section saillante (32) qui fait saillie depuis le semi-conducteur (10) de puissance et/ou depuis la feuille métallique de base (20) et/ou depuis la feuille métallique supérieure (40) dans une vue en plan.

8. Dispositif (1) à semi-conducteurs de puissance de la revendication 7, dans lequel la PCB flexible (30) comprend en outre une piste conductrice (35) reliant électriquement la pastille d'alimentation de grille (16) à un connecteur de grille (36) pour un contact externe, le connecteur de grille (36) étant positionné dans la section saillante (32) de la PCB flexible (30).

9. Dispositif à semi-conducteurs de puissance de l'une des revendications 1 à 8, dans lequel la feuille métallique de base (20) et/ou la feuille métallique supérieure (40) est en cuivre ou comprend du cuivre, et dans lequel les feuilles métalliques de base et/ou supérieure (20, 40) comprennent un connecteur (28a, 28b, 48) pour un contact externe.

10. Dispositif à semi-conducteurs (10) de puissance de l'une des revendications 1 à 9, comprenant en outre un dissipateur thermique (70) fixé sur le côté de la feuille métallique de base (20) à l'opposé de la PCB flexible (30).

11. Système de batterie comprenant une unité de commande de batterie (100) reliée électriquement à un dispositif (1) à semi-conducteurs de puissance de l'une des revendications 1 à 10, l'unité de commande de batterie (100) étant configurée pour commander le dispositif (1) à semi-conducteurs de puissance.

12. Véhicule comprenant un système de batterie selon la revendication 11.
